# EUROPEAN PATENT APPLICATION

(11) **EP 1 298 710 A1**
(43) Date of publication of application: **02.04.2003**
(21) Application number: 01121475.6
(22) Date of filing: 07.09.2001
(51) Int. Cl.: H01L 21/28, H01L 21/336, H01L 21/318, H01L 21/8242, H01L 21/324, H01L 29/49, H01L 29/78, H01L 27/108

(54) **Method for protecting a tungsten element in semiconductor device fabrication**

(71) Applicant: Infineon Technologies AG, 81669 München (DE)
(72) Inventor: Cappellani, Annalisa, I-96100 Siracusa (IT)
(74) Representative: Müller - Hoffmann & Partner

(57) **Abstract**

To avoid the formation of tungsten whiskers during high temperature processing steps it is suggested in a method for processing a semiconductor device (1) to perform an intermediate nitridation processing step at least on a given tungsten surface area (30a) at an intermediate processing temperature (Tn) below said high processing temperature (Th) so as to form a nitridized tungsten surface layer (32) as an oxidation blocking layer to avoid the formation of tungsten whiskers.

## Description

The present invention relates to a method for processing a semiconductor device or the like, which is in particular included in a process of manufacturing a DRAM device or the like.

Many semiconductor devices use as materials for connections and interconnections between different areas of the device polysilicon or polycide. In the case where low resistances or low resistivities of such connections or interconnections are required, in particular to suppress RC-delays of the respective connections or interconnections, it has been suggested to use poly-metal or full-metal structures instead of polysilicon or polycide arrangements. In particular tungsten W is commonly used as such a metal for this purpose.

In many methods for processing semiconductor devices it is necessary to further process at relative high processing temperatures a semiconductor arrangement having formed inside or on the surface thereof the metal section and in particular a tungsten section.

Under these circumstances it is in general not possible to avoid an adsorption and thereby a contamination of the tungsten surface area with respect to oxygen or the like. When performing a high temperature processing step, such as a annealing process or a high temperature deposition process, it turns out that the adsorbed oxygen on the tungsten surface area may form tungsten oxide WO₃ or WO₂. Said tungsten oxide WO₃ appears on the surface as so-called tungsten whiskers, so that the further processed, i.e. coated or annealed, tungsten surface area appears disadvantageously rough and undulated.

It is therefore an object of the present invention to provide a method for processing a semiconductor device in which the surface properties of tungsten surface areas can be maintained with a reasonable quality.

The object is achieved by a method according to the generic part of claim 1 with the characterizing features of claim 1. Preferred embodiments of the inventive method for processing a semiconductor device are within the scope of the dependent subclaims.

In known methods for processing semiconductor devices or the like, in particular in a process of manufacturing a DRAM device or the like, at first a semiconductor section having at least one semiconductor surface area is formed. As mentioned above one or more tungsten sections within said semiconductor section are formed which have tungsten surface areas being a part of said semiconductor surface area. With respect to this structure at least one high temperature processing step at a relative high processing temperature Th is performed with having at least said tungsten surface area or a part thereof exposed to a given high temperature processing ambient atmosphere.

The inventive method for processing a semiconductor device is characterized in that before said high temperature processing step an intermediate nitridation processing step is performed at least on said tungsten surface area. Said intermediate nitridation processing step is performed at an intermediate processing temperature Tn which is below said high processing temperature. Thereby, a nitridized tungsten surface layer is formed as or on said tungsten surface area as an oxidation blocking layer or the like, and/or in particular avoiding the formation of tungsten whiskers or the like, in particular during the high temperature processing step.

It is therefore a basic idea of the present invention to avoid the formation of tungsten whiskers on the tungsten surface area during the high temperature processing step by performing in advance said high temperature processing step an intermediate nitridation processing step. This intermediate nitridation processing step is carried out at an intermediate processing temperature Tn below said high processing temperature. The tungsten surface area is nitridized with an nitridized tungsten surface layer which acts as an oxidation blocking layer.

According to a preferred embodiment of the inventive method said intermediate nitridation step is carried out in an ammonia atmosphere or in an ammonia containing atmosphere as an intermediate temperature processing ambient atmosphere.

Preferably, said intermediate temperature processing ambient atmosphere is set to a pressure of about 1 Torr or higher.

Further, the intermediate processing temperature Tn is chosen to be about 500°C or higher.

The known schemes or sequences for processing semiconductor devices can essentially be maintained when, according to a further preferred embodiment of the inventive method, said intermediate nitridation step is included into or performed during a process of increasing the processing temperature from a relative low processing temperature Tr, for instance from room temperature, to said relative high processing temperature Th.

The inventive method for processing a semiconductor device advantageously comprises at least a high temperature annealing step for said semiconductor device as said high temperature processing step.

On the other hand, the inventive method for processing a semiconductor device may comprise a step of coating at least said semiconductor surface area with hard mask or spacer elements, in particular using silicon nitride or the like.

The inventive method for processing a semiconductor device gives benefits when comprising as said high temperature processing step a LPCVD and/or a PECVD process or the like.

Further benefits are obtained when said high processing temperature Th is set to a temperature of about 700°C or higher.

There are several ways to carry out the intermediate nitridation step. According to a further preferred embodiment said intermediate nitridation processing step is performed at an intermediate processing temperature Tn of about 600°C as a thermal nitridation step.

Alternatively, said intermediate nitridation step can be performed below a tungsten oxidation temperature, which is about 450°C, and in particular at a temperature of about 300°C, i.e. below said oxidation temperature, and further in particular using a PECVD method and/or using an energy and/or a back bias of about 500 W.

Although the inventive method can be applied in processes for arbitrary semiconductor devices it is of particular advantage when in said method said tungsten section is formed as a gate section of a MOSFET arrangement or the like, in particular of a cell selection transistor for a DRAM device or the like.

In the following, some remarks are given, which may further elucidate advantages of the present invention:

Low resistivity gate interconnects are required for the suppression of the gate RC delay. To realise low resistance gate the standard polysilicon or polycide gate can be replaced by a polymetal of full metal structure. Tungsten W is commonly used as metal for this purpose. A silicon nitride Si₃N₄ layer needs to be deposited as hard mask and as spacers in case a self aligned contact is required. In particular an LPCVD Si₃N₄ layer is often used for this purpose due to the high step coverage, high thermal stability and high density and purity. But when Si₃N₄ is deposited an abnormal crystal growth of W is observed. In particular W forms long spikes called W whiskers. This makes the integration of metal or poly/metal gates impossible. The W whiskers formation is possibly due to W oxidation during the wafers load in in the LPCVD chamber. In fact, normally the chamber stand by temperature is of the order of 700°C, while the deposition itself can be done at higher temperatures, such as 715°C or even higher such as 800°C. The wafers wait in a pre-chamber before to be loaded in. The chamber is only purged with N₂ but the oxygen contamination cannot be stopped. W oxidises very easily if it is exposed at oxygen under a temperature higher than 450°C.

Ideally the loading temperature should be lowered down to 400°C, but this would increase the risk of particle formation inside the chamber due to the ramp up and down of the chamber temperature. The solution could be the introduction of an intermediate step between the loading step at a temperature not too low such as 500°C and the ramping up temperature step for Si₃N₄ deposition such as 715 - 800°C. The additional step is a NH₃ reduction step, in which ammonia is introduced in the chamber at high pressure, e.g. 1 Torr or higher. During this step the hydrogen H contained in the ammonia gas will reduce the W surface already oxided, removing the WO₃ from the W surface and instead nitradising the W surface. The step can be included without changing much the process temperature. In fact the step itself may last around 6 - 7 hours. The nitridation step will add no more than 30 minutes process time. Not a significant change in the process time required. The step may also easily performed in the LPCVD chamber.

The proposal suggests the introduction of a nitridation step before the LPCVD Si₃N₄ layer deposition. During this step the H will reduce the WO₃ on the W surface cleaning the surface from the Oxigene contamination. Also the surface will be nitrided so that the Si₃N₄ layer will be more uniformly deposited.

The fabrication procedure may be implemented as follows:
1. Load in wafers in the load look at room temperature. Load lock closed and evacuated. Loading of the wafers in the pre-chamber.
2. Load wafers in the processing chamber at temperature higher than 500°C.
3. Nitridation step at this temperature and at high pressure of 1 Torr or higher using NH₃ gas. During this step the W surface is cleaned from the O contamination by a reduction mechanism enhanced by the H presents in the ammonia.
4. The oxygen free W surface so nitrided can be ramped up to the processing temperature.
5. The LPCVD layer can be deposited without the formation of the W-whisker.

The problem is that W reacts with oxygen at temperatures higher than 500°C, oxygen can be on the W surface as a surface contamination and can be in the process chamber as a background contamination (few ppm).

The proposed solution comprises a step of cleaning the W surface by a pre-nitradation process (NH₃ + N₂), thermal or plasma enhanced. The H reduces the WO₃ and the process will form W-N bonds acting as a barrier for WO₃ formation.

The nitradation processes may have the following form:
- LPCVD: at high pressure (> 1 Torr), Tn >= 600°C, time >= 30 min
- PECVD: at high power (∼ 500 W for high ion energy) and time ∼ 30 sec, Tn ∼ 300°C (below W oxidation temperature).

In the following some examples are given in which the inventive method is included in particular process flows. Example 1 describes an embodiment of the inventive method including a LPCVD Si₃N₄ deposition at a temperature of about 725°C. Example 2 describes embodiments of the inventive method including an annealing process in an inert ambient atmosphere at high temperatures of about 1050°C. For each of the examples 1 and 2 a one step process and a two step process are explained:

**TABLE 1:**

| Example 1: LPCVD SiN deposition at 725°C | |
|---|---|
| process flows: | Pros/Cons: |
| 1 step process: | • Pros: 1 process step in 1 tool |
| • Load in LPCVD furnace at 600°C or lower | |
| | • Cons: furnace must be ramp down at low temperature for load in/nitridation → risk of particles |
| • Thermal nitradation step at this low temperature | |
| • then ramp up at the deposition temperature (725°C) | |
| 2 steps process: | • Pros: no process complexity, short process |
| • Nitradation in PECVD tool | |
| • Load in LPCVD furnace at 700°C | (30 sec), no risk of particles |
| • then ramp up at the deposition temperature (725°C) | • Cons: additional step in different tool |

**TABLE 2:**

| Example 1: Annealing in inert ambient at high temperature | |
|---|---|
| process flows: | Pros/Cons: |
| one step process: | • Pros: 1 process step in 1 tool |
| • Load in RTP/furnace at room temperature | |
| | • Cons: low temp nitridation require long time |
| • Thermal nitradation step at low temperature (e.g. 600°C) | |
| • then ramp up at the annealing temperature (e.g. 1050°C) | |
| two steps process: | • Pros: short process (30 sec), additional protection against O₂ background |
| • Nitradation in PECVD tool | |
| • Load in RTP/furnace at room temperature | |
| • then ramp up at the annealing temperature (e.g. 1050°C) | • Cons: additional step in different tool |

The invention will become more apparent taking reference to the accompanying figures.

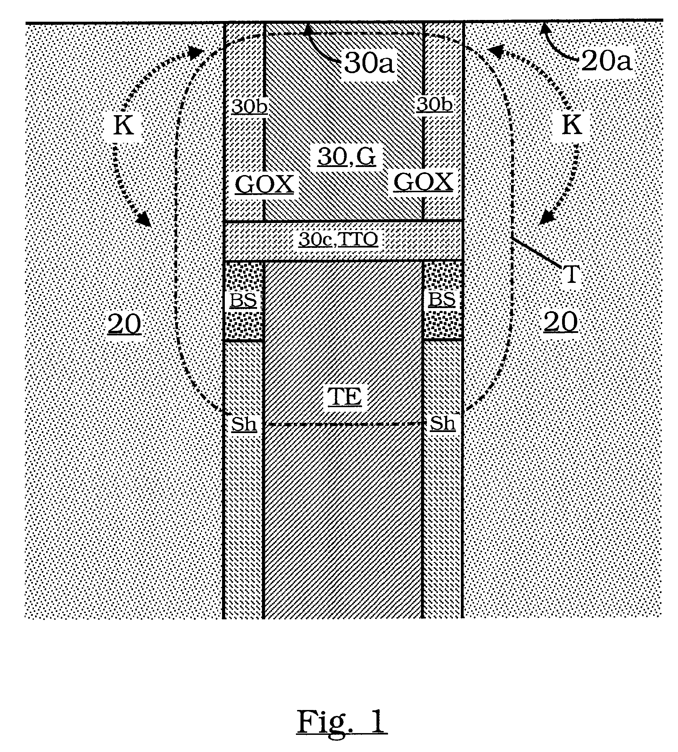

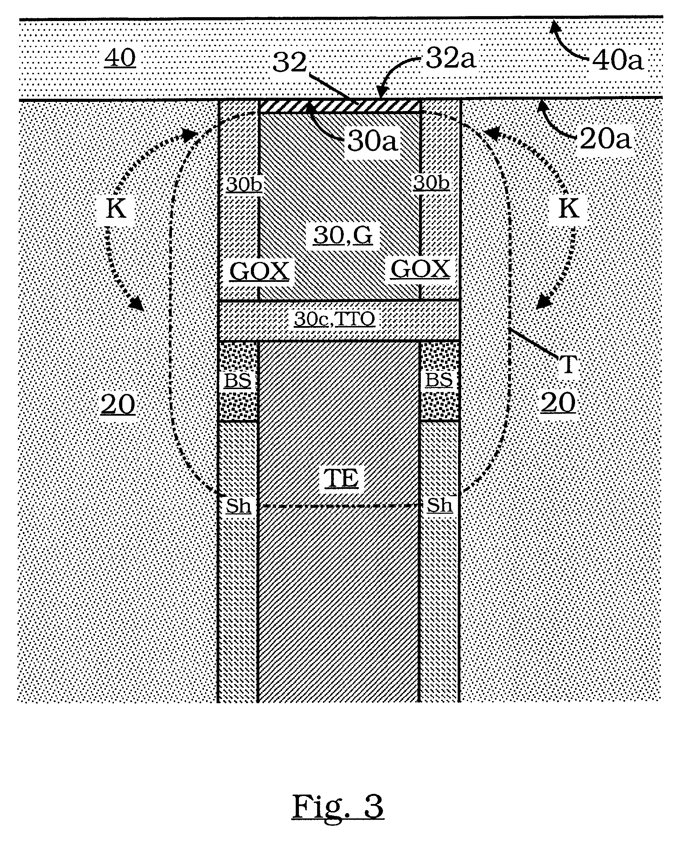

- Fig. 1 - 3: are schematical cross-sectional views elucidating intermediate stages with respect to example of an embodiment of the inventive method for processing a semiconductor device.

In a first intermediate stage of the described embodiment of the inventive method for processing a semiconductor device 1 in a semiconductor substrate 20 with a planar semiconductor surface area 20a a tungsten section 30, W is formed having a tungsten surface area 30a which is a part of the semiconductor surface area 20a.

The tungsten section 30 acts as an gate section G of a vertical field effect transistor T is formed as a deep trench transistor. Therefore, the tungsten section 30 or the gate section G is surrounded on its sidewall areas 30b by the so-called gate oxide GOX and on the bottom area 30c by the so-called trench top oxide TTO.

Below the trench top oxide TTO there is a top electrode connection section TE for the top electrode of an storage capacitor, both of which are not shown in Fig. 1. The top electrode connection TE is shielded against the semiconductor section 20 by a shielding SH.

Right below the trench top oxide TTO the so-called buried strap region BS is included in the sidewalls Sh of the top electrode connection TE so as to build, e.g. by an ion diffusion process of a certain dopant an overlap region with the gate oxide GOX to form a conduction channel K and to define a source/drain region SD of the vertical field effect transistor T.

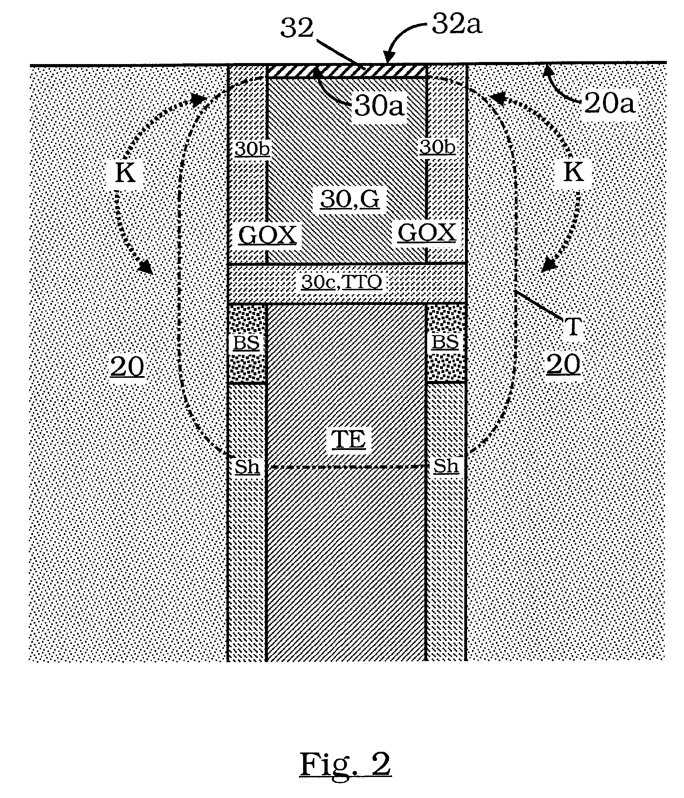

In the transition from the stage of the Fig. 1 to the stage of the Fig. 2 the tungsten surface area 30a is nitridized so that a nitridized tungsten surface layer 32 covers the tungsten section 30 as an protection layer.

Then a high temperature processing step can be performed on the arrangement shown in Fig. 2, avoiding in the high temperature region an oxidation process with respect to adsorbed oxygen molecules on the tungsten surface area 30a as said adsorbed oxygen molecules are replaced or displaced.

The surface area 32a of the nitridized tungsten layer 32 is still essentially planar so that when coating the arrangement of Fig. 2 with an silicon nitride hard mask layer 40 the surface area 40a of the latter remains planar, in contrast to prior art methods, in which the tungsten whiskers impinge their undulation from the undulated tungsten surface area 40a to the respective surface area 50a of the hard mask layer 40.

### Reference numerals

- 1: semiconductor device
- 20: semiconductor section
- 20a: semiconductor surface area
- 30: tungsten section
- 30a: tungsten surface area
- 30b: sidewall section
- 30c: bottom section
- 32: oxidation blocking layer, nitridized tungsten layer
- 32a: surface area
- 40: hard mask, silicon nitride
- 40a: surface area
- 100: high temperature processing ambient atmosphere
- 102: intermediate temperature processing ambient atmosphere
- BS: buried strap region
- G: gate region, gate section
- GOX: gate oxide region
- Sh: shielding
- TE: top electrode connection
- T: transistor device
- TTO: trench top oxide

## Claims

1. Method for processing a semiconductor device or the like, in particular in a process of manufacturing a DRAM device or the like, comprising the steps of:
- forming a semiconductor section (20) having at least one semiconductor surface area (20a),
- forming a tungsten section (30) within said semiconductor section (20) and having a tungsten surface area (30a) being a part of said semiconductor area (20a), and
- performing on said semiconductor section (20), said tungsten section (30), and/or the surface areas (20a, 30a) thereof at least one high temperature processing step at a relative high processing temperature (Th) with having at least said tungsten surface area (30a) or a part thereof exposed to an high temperature processing ambient atmosphere (100),
**characterized in that**
- before said high temperature processing step an intermediate nitridation processing step is performed at least on said tungsten surface area (30a) at an intermediate processing temperature (Tn) below said high processing temperature (Th), and
- thereby forming a nitridized tungsten surface layer (32) as an oxidation blocking layer or the like, and/or in particular for avoiding the formation of tungsten whiskers or the like.

2. Method according to claim 1, wherein said intermediate nitridation processing step is carried out in an ammonia atmosphere or ammonia containing atmosphere as an intermediate temperature processing ambient atmosphere (102).

3. Method according to claim 2, wherein said intermediate temperature processing ambient atmosphere (102) is set at a pressure of about 1 Torr or higher.

4. Method according to anyone of the preceding claims, wherein said intermediate processing temperature (Tn) is chosen to be about 500°C or higher.

5. Method according to anyone of the preceding claims, wherein said intermediate nitridation processing step is included into or performed during a process of increasing the processing temperature from a relative low processing temperature (Tr), for instance room temperature, to said relative high processing temperature (Th).

6. Method according to anyone of the preceding claims, wherein said high temperature processing step at least comprises a high temperature annealing step for said semiconductor device (1).

7. Method according to anyone of the preceding claims, wherein said high temperature processing step at least comprises a step of coating at least said semiconductor surface area (20a) with hard mask (40) or spacer elements, in particular using silicon nitride Si₃N₄ or the like.

8. Method according to anyone of the preceding claims, wherein said high temperature processing step at least involves a LPCVD and/or PECVD process or the like.

9. Method according to anyone of the preceding claims, wherein the high processing temperature (Th) is set to be about 700°C or higher.

10. Method according to anyone of the preceding claims, wherein said intermediate nitridation processing step is performed at an intermediate processing temperature (Tn) of about 600°C as a thermal nitridation processing step.

11. Method according to anyone of the claims 1 to 9, wherein said intermediate nitridation processing step is performed at an intermediate processing temperature (Tn) below a tungsten oxidation temperature of about 450°C and in particular at a temperature of about 300°C, in particular using a PECVD method or the like and/or with an energy and/or a back bias of about 500 W.

12. Method according to anyone of the preceding claims, wherein said tungsten section (30) is formed as a gate section (G) of a MOSFET arrangement or the like, in particular of a cell selection transistor (T) for a DRAM device (1) or the like.
